(19) Europäisches Patentamt
European Patent Office
Office européen des brevets

(11) **EP 2 676 131 B1**

(12) **EUROPÄISCHE PATENTSCHRIFT**

(45) Veröffentlichungstag und Bekanntmachung des Hinweises auf die Patenterteilung:
**07.01.2015 Patentblatt 2015/02**

(21) Anmeldenummer: **12709785.5**

(22) Anmeldetag: **14.02.2012**

(51) Int Cl.:
***G01N 29/44*** *(2006.01)*

(86) Internationale Anmeldenummer:
**PCT/EP2012/000640**

(87) Internationale Veröffentlichungsnummer:
**WO 2012/110228 (23.08.2012 Gazette 2012/34)**

(54) **VERFAHREN ZUR REDUKTION VON ULTRASCHALLDATEN**

METHOD FOR REDUCING ULTRASONIC DATA

PROCÉDÉ DE RÉDUCTION DE DONNÉES ULTRASONIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.02.2011 DE 102011011530**

(43) Veröffentlichungstag der Anmeldung:
**25.12.2013 Patentblatt 2013/52**

(73) Patentinhaber: **Karlsruher Institut für Technologie 76131 Karlsruhe (DE)**

(72) Erfinder:
• **GEMMEKE, Hartmut**
  **76297 Stutensee (DE)**
• **STRIPF, Helmut**
  **76344 Eggenstein-Leopoldshafen (DE)**
• **RUITER, Nicole**
  **76448 Durmersheim (DE)**

(56) Entgegenhaltungen:
**WO-A1-98/26309          DE-A1- 4 040 190**
**DE-B3-102005 005 386**

• **BALZER M ET AL: "Online data reduction with a dsp-fpga multiprocessor system", DIGITAL SIGNAL PROCESSING, 2002. DSP 2002. 2002 14TH INTERNATIONAL CON FERENCE ON SANTORINI, GREECE 1-3 JULY 2002, PISCATAWAY, NJ, USA,IEEE, US, Bd. 2, 1. Juli 2002 (2002-07-01), Seiten 819-822, XP010599978, ISBN: 978-0-7803-7503-1**
• **FIGUEROA J F ET AL: "A METHOD FOR ACCURATE DETECTION OF TIME OF ARRIVAL: ANALYSIS AND DESIGN OF AN ULTRASONIC RANGING SYSTEM", THE JOURNAL OF THE ACOUSTICAL SOCIETY OF AMERICA, AMERICAN INSTITUTE OF PHYSICS FOR THE ACOUSTICAL SOCIETY OF AMERICA, NEW YORK, NY, US, Bd. 91, Nr. 1, 1. Januar 1992 (1992-01-01) , Seiten 486-494, XP000248408, ISSN: 0001-4966, DOI: 10.1121/1.402734**

**Beschreibung**

Die Erfindung betrifft ein Verfahren zur Reduktion von Ultraschalldaten gemäß des ersten Patentanspruchs.

Ein Ultraschallsignal wird durch Anregung eines als Sender eingesetzten Ultraschallwandlers erzeugt. Im zu prüfendem Medium wird der Ultraschall geschwächt und/oder an Grenzflächen reflektiert. Das auf diese Weise manipulierte Ultraschallsignal wird anschließend von einem als Empfänger eingesetzten Ultraschallwandler empfangen, wobei über einen Vergleich des gesendeten mit dem empfangenen Ultraschallsignal neben der Laufzeit auch Schwächung bzw. Reflektion durch das zu prüfende Medium detektiert wird.

Die mit den Sensoren gewonnenen Messdaten werden in elektrisch analoge Signale gewandelt und in einem Analog-Digitalwandler zu digitalen Ultrasachalldaten digitalisiert. Sie enthalten die von Ultraschallwandlern empfangenen Antwortsignale, die bei einem Durchschallungsverfahren oder einem Echoverfahren als Antwort eines Ultraschallsignals erzeugt werden. Beispielhafte Anwendungen, bei denen digitalisierte Ultraschalldaten generiert werden seien die medizinische Ultraschalldiagnostik sowie die Ultraschallgestützte Werkstoff- und Bauteilprüfung genannt. Bei vielen dieser Ultraschallanwendungen bleibt die Datenmenge begrenzt, sodass deren Speicherung für eine anschließende Off-Line-Auswertung problemlos möglich ist. Die Ultraschalldaten werden nach Generierung entweder in Echtzeit oder nach einer Zwischenspeicherung einer anschließenden separaten Weiterverarbeitung oder Verwendung zugeführt.

Bei komplexen Ultraschallprüfanwendungen, wie z.B. bei tomographischen Verfahren, z.B. bei tomographischen 3D-Ultraschallverfahren (USCT) oder bei über einen längeren Zeitraum autark arbeitenden Ultraschallprüfsystemen, z.B. bei der Riss- oder Korrosionsprüfung an Rohrleitungen oder Pipelines, ist jedoch mit einer signifikant erhöhten Menge an Ultraschalldaten zu rechnen. Eine Weiterverarbeitung dieser in Echtzeit z.B. zu tomographischen Abbildungen erfordert jedoch sehr hohe Rechenleistungen. Ist eine Auswertung in Echtzeit nicht erforderlich, müssen die Datenmengen in entsprechend dimensionierenden Speicherelementen zwischengespeichert werden.

Speziell beim Prüfen von Rohrleitungen, insbesondere für den Öl- oder Gastransport, sind sog. Prüfmolche bekannt, die an ihrer äußeren Mantelwand um den Umfang eine Vielzahl von Ultraschallwandlern (typischerweise ca.900 Einzelwandler) vorgesehen sind. Zur Überprüfung der Rohrleitung wird der Molch in die Leitung eingeschleust und mit dem Leitungsinhalt durch diese transportiert. Mit den Wandlern wird der Zustand der Rohrleitung dabei laufend überprüft; die Ultraschalldaten molchintern für eine anschließende Auswertung abgespeichert. Beim Lauf durch eine lange Öl-/Gasleitung fallen aufgrund der Vielzahl der Ultraschallwandler einerseits und den länger andauernden Messungsdurchläufe durch die Pipeline sehr große Datenmengen an. Bei einer Rohrleitungsprüfung mit einem Prüfmolch mit 900 Ultraschallwandlern, die zumindest teilweise im Multiplexbetrieb betrieben werden, und einer Prüfgeschwindigkeit von 1 m/sec (Geschwindigkeit des Prüfmolchs in der Leitung) fallen auf einer Pipelinestrecke von 500 km Länge eine Datenmenge von ca. 900 TByte an, mit einer Datenrate von ca. 2.8GByte/sec. Während eines solchen Laufes ist ein solcher Molch nicht mit der Außenwelt verbunden. Die anfallenden Daten müssen daher in einer Form gespeichert werden, die außerhalb der Rohrleitung nach dem Lauf eine Rekonstruktion des Wandzustandes zulässt, der Abnormalitäten/Verletzungen/Defekte an der Rohrwand ortsbestimmbar und zuverlässig quantifizierbar ermöglicht. Eine Speicherung der anfallenden Datenmengen erscheint selbst mit aktuellen Speichermedien als praktisch oder wirtschaftlich nicht umsetzbar.

Aber auch in der medizinischen Sonographie fallen insbesondere bei komplexen Anwendungen wie z.B. die Tomographie oder bei hochauflösenden Anwendungen in sehr kurzer Zeit eine sehr große Datenmenge an, beispielsweise in der Größenordnung von 20 GByte bei der tomographischen Mammographie mittlerer Auflösung allein an einer Brust. Diese sehr große Datenmenge ist zwar in einem ortsfesten Speicher zwar problemlos speicherbar ist, aber deren Auswertung aufgrund der großen Rohdatenmenge ohne eine Vorabselektion eine sehr hohe und damit teure Rechnerleistung erfordert. Zur Sicherstellung einer Darstellung (Rekonstruktion) in Echtzeit müssen die aus den Analogwerten anfallenden Digitaldaten reduziert/komprimiert werden.

Datenreduktionsverfahren bei der Schadenserfassung dienen also dazu, die wesentlichen Merkmale eines mit einer Anomalie oder einem Defekt der Rohrwand oder des Gewebes in Zusammenhang gebrachten Signals zu extrahieren und mit einer Mindestzahl von Bits so genau wie möglich darzustellen, um so die Menge der zu speichernden Daten zu reduzieren/minimieren.

Damit sich die Datenmenge in abspeicherfähigen Größenordnungen bewegt und der Molch eine wirtschaftliche Laufweite erreicht, der notwendige Zwischenspeicher für den Prüfmolch oder für die Ultraschall Computer Tomographie ausreicht, muss zwingend eine Datenreduktion durchgeführt werden. Eine Zwischenspeicherung vor einer anschließenden Datenauswertung ist insbesondere bei autark arbeitenden Systemen wie die vorgenannten Molchsysteme nicht oder nur mit erheblichem Speicheraufwand möglich, eine Datenreduktion oder Datenselektierung vor der Speicherung daher sinnvoll.

Datenreduktionsverfahren dienen dazu alle für eine weitere Bearbeitung wesentlichen Merkmale aus den Ultraschalldaten zu extrahieren und mit einer reduzierten Zahl an Bits abzulegen. Durch Kenntnis der Struktur der Daten und deren Gewichtung z.B. für die nachträgliche (offline) Defektbestimmung kann man durch die Entwicklung einer speziellen an die Anforderungen der Signalauswertung angepassten Reduktionsmethode deutlich höhere Reduktionsfaktoren erzielen.

Einen Ansatz hierzu offenbart **[1]**. Das hierin beschriebene Verfahren selektiert die Spitzen einer Ultraschallsignaleinhüllenden anhand der Maxima von Halbwellen. Bei einer Signalfolge mit einer Anzahl wiederkehrender ähnlich hohen Amplituden von Halbwellen, wie sie insbesondere beim Ultraschall-Echo-Verfahren gemessen werden, ist eine Spitzenwertauswahl bei der Bestimmung der Laufzeit jedoch wesentlich schwankungsintensiver im Vergleich zu einer Zeitbestimmung in der Flanke der Einhüllenden.

In **[2]** wird ein Reduktionsverfahren beschrieben bei dem für jeden digital gefilterten Reflexionsimpuls Zeitpunkt und Amplitude für das Maximum erfasst werden. Das Verfahren bewertet jedoch nicht die Breite und Charakteristik der Einhüllenden (Envelopen), weswegen es zu Ungenauigkeiten insbesondere bei Bestimmung der Impulshöhe kommt. Darüber hinaus verlangt das Verfahren ein mit einem Tiefpassfilter geglättetes Ultraschallsignal.

Ferner wird in **[3]** ein Verfahren zur Reduktion speziell von digitalisierten Daten einer Vielzahl elektronmagnetischer Messaufnehmer in einem sog. EMAT-Molch (Electro Magnetic Acoustic Transducer Crack Detection) für die Erfassung von Defektstellen in Blechen oder Rohren beschrieben. Das Verfahren basiert auf einem Algorithmus zur Auswahl von Maxima aus einer Folge von Spitzenwerten der gemessenen Werte und umfasst einerseits eine Größenbestimmung einer Defektstelle und der Bestimmung des Signaluntergrunds im Nachbarbereich einer Defektstelle. Für die Datenkomprimierung für eine Ultraschallechosignalfolge mit mehreren Spitzenwerten mit nahezu gleichen Amplituden kommt es jedoch auf die exakte Bestimmung von Laufzeiten an, die mit dem genannten Verfahren zu ungenau ist.

Folglich liegt die **Aufgabe der Erfindung** darin, ein Verfahren zur Reduktion von aus Messwerten gewonnenen digitaler Ultraschallmessdaten bereitzustellen, das eine Datenreduktion um den Faktor 10 bis 500 ermöglicht und gegenüber dem zitierten Stand der Technik insbesondere eine verbesserte Erfassung von Laufzeiten und Impulshöhen der Ultraschallimpulse sicherstellt.

Die Aufgabe wird mit einem Verfahren mit den Merkmalen des ersten Patentanspruchs gelöst. Die auf diesen rückbezogene Unteransprüche geben vorteilhafte Ausführungsformen wieder.

Die wesentlichen Verfahrensschritte basieren auf einem Algorithmus zur Auswahl von Werten, der Amplituden-Laufzeit-Paare, Vektoren, liefert, welche die Maxima der Ultraschall-Einhüllenden anzeigen. Die Laufzeit-Paare werden hier mit Vektoren bezeichnet.

Das Verfahren zur Reduktion von Ultraschalldaten aus einem Ultraschallsignal umfasst bevorzugt die folgenden Verfahrensschritte:

1. Gleichrichtung des Ultraschallsignals:

   Dieser Schritt umfasst im Wesentlichen eine Konvertierung der negativ gepolten Signalteile in positive Signalteile, d.h. eine Umklappung der Signale in den positiven Spannungsbereich. Optional erfolgt eine vorangegangene Filterung der Ultraschalldaten.
   2. Generierung einer Umhüllungskurve des gleichgerichteten Ultraschallsignals, die sich an den Maximalwerten orientiert (Envelope), wobei sich die Ultraschallimpulse als einfachen Maximalwerte darstellen,
   3. Generierung eines negativen und um einen Faktor bevorzugt zwischen 0,2 und 0,8, weiter bevorzugt zwischen 0,3 bis 0,6 reduzierten Umhüllungskurvensignals sowie eines unveränderten, jedoch verzögerten Umhüllungskurvensignals
   4. Addition des negativ reduzierten und des verzögerten Umhüllungskurvensignals zu einem Summensignal, wobei das Summensignal einen Nulldurchgang aufweist und der Nulldurchgang einen Zeitwert (Triggersignal) darstellt sowie
   5. Zuordnung einer Amplitude zum Zeitwert, wobei die Amplitude einer Signalhöhe entsprechend einer maximalen Peakhöhe aus der Umhüllungskurve innerhalb eines Zeitintervalls um den Zeitwert entspricht

Das Verfahren zur Reduktion von Ultraschalldaten aus einem Ultraschallsignal ermöglicht im Rahmen einer ultraschallgestützten Rohrleitungsprüfung abhängig von dem Zustand der Pipeline eine Datenreduktion um einen bevorzugten Faktor von ca. 100 bis 300 und bei ultraschallgestützten Gewebeuntersuchten von Organen einen bevorzugten Faktor 10 bis 20. Die reduzierte Datenmenge kann dann auf robuste, schock- und temperaturresistente Massenspeicher abgelegt werden.

Das Verfahren wird im Folgenden an einem Beispiel aus der Ultraschall-Wanddickenmessung einer Rohrwand beispielhaft aufgezeigt. Es zeigen

**Fig.1** beispielhaft einen Aufbau und die Ultraschallsignallaufwege einer ultraschallgestützten Wanddickenmessung (Impuls-Echo-Verfahren),

**Fig.2a** ein durch einen Ultraschallprüfkopf in der in **Fig.1** dargestellten Konfiguration empfangenen Ultraschallsignale,

**Fig.2b** die gleichgerichteten Ultraschallsignale gem. **Fig.2a** mit der Umhüllungskurve,

**Fig.3** eine Ausschnittsvergrößerung im Zeitintervall um das dritte Nebenmaximum (Ultraschallimpuls) gem. **Fig.2b,**

**Fig.4** das Umhüllungskurvensignal gem. **Fig.3** sowie ein negatives und um einen Faktor 0,3 bis 0,6 reduziertes Umhüllungskurvensignal, ein unverändertes, jedoch um eine Zeitspanne $t_d$ verzögerten Umhüllungskurvensignal sowie ein Summensignal aus negativ reduzierten und verzögerten Umhüllungskurvensignals mit einem Nulldurchgang,

**Fig.5** das Umhüllungskurvensignal gem. **Fig.3,** sowie einen Ultraschallvektor zum Zeitpunkt des Nulldurchgangs in **Fig.4** und mit der maximalen Höhe des Ultraschallkurvensignals,

**Fig.6** das Umhüllungskurvensignal gem. **Fig.3 und 5** mit zwei Ultraschallvektoren an Nulldurchgängen bei verschiedenen f

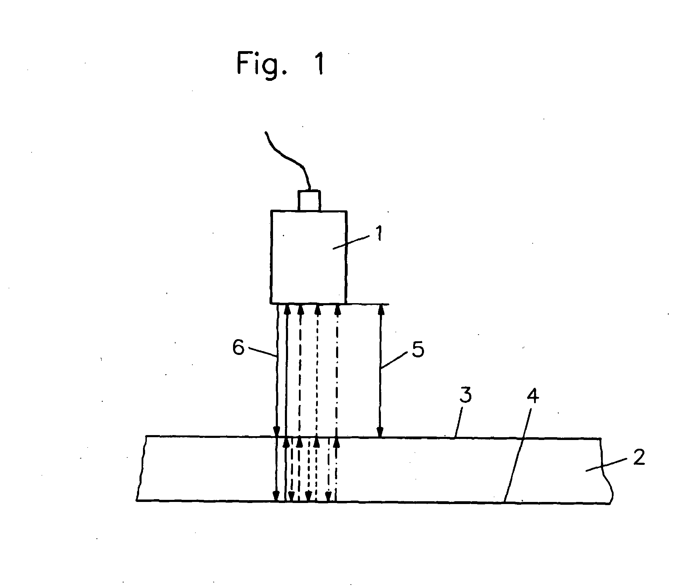

Die grundlegende Anordnung eines Ultraschallsystems an einem zu prüfenden Objekt (Rohrwandung) ist beispielhaft an einer Platte in **Fig.1** in vereinfachter Prinzipskizze dargestellt. Zwischen dem Ultraschallprüfkopf **1** des Ultraschallsystems und dem zu prüfenden Objekt, eine Rohrwandung **2** mit einer Innen- und Außenwand **3** bzw. **4** als Reflexionsebenen ist eine Vorlaufstrecke **5** vorgesehen. Die Vorlaufstrecke dient der Einstellung einer bestimmten Zeitverzögerung zwischen dem Sendesignal und dem erstmöglich zu empfangenen Impulssignal von der nächstliegenden Reflexionsebene. Sie durchläuft meist ein flüssiges oder festes Medium und ist dabei integraler Bestandteil eines Ultraschallsystems.

Grundsätzlich entspricht die Anordnung der für sonographische Diagnosen, wobei jedoch die Reflexionsebenen sowie das zu untersuchende Gewebe zu diffuseren Echoimpulsen führen.

Der durch einen Anregungsimpuls am Ultraschallprüfkopf **1** ausgelöste Ultraschallimpuls durchläuft eine Vorlaufstrecke **5,** wird zu einem Teil an der Innenwand **3** reflektiert und gelangt zum Ultraschallprüfkopf zurück. Die restliche Schallenergie dringt in die Rohrwandung **2** z.B. aus Stahl ein, wird zu einem großen Teil an der Rohr-Außenwand **4** reflektiert, wovon ein Teil zum Ultraschallprüfkopf zurück gelangt (erstes Rückwandecho-Signal), vom Rohrinnern aus gesehen - und der übrige Teil erneut an der Innenwand innen reflektiert wird. Diese im Wandinnern an der Rohr-Innenwandung reflektierte Restsignal wird an der Außenwand **4** wieder teils nach außen transmittiert und der Rest nach innen reflektiert, um innen an der Innenwand **3** wiederum teils transmittiert zu werden, das als zweites Rückwandecho-Signal im Ultraschallprüfkopf empfangen wird. Der an der Innenwand **3** in das Wandungsinnere in Richtung der Außenwand **4** reflektierte Anteil wird bei Erreichen dieser wie zuvor beschrieben erneut an der Außenwand transmittiert und/oder reflektiert. Der danach erneut an der Innenwand transmittierte Anteil des an der Außenwand reflektierten Anteils tritt schließlich als drittes Rückwandecho im Ultraschallprüfkopf ein je nach Schallschwächung kommt es zu weiteren Reflexionen innerhalb der Rohrwandung. Die einzelnen Schalllaufwege sind durch Pfeile **6** schematisch dargestellt, wobei jeder Rücklauf bei einer Reflexion zur visuellen Deutlichkeit nach rechts versetzt sowie das zweite und vierte Rückwandecho als gestrichelte Linien dargestellt sind.

Anhand der bekannten Schallgeschwindigkeit im Wandungsmaterial und der gemessenen Zeiten zwischen den einzelnen Echos lassen sich die Schallaufzeiten durch die Rohrwandung messen und damit die Wanddicke der Rohrwandung ermitteln.

Die in den folgenden Figuren dargestellten Ergebnisse wurden an einer Ultraschallwanddickenmessung von Rohrleitungswandungen aus dem Rohrinnern mit den eingangs genannten Molchsystemen gewonnen. Die Vektorisierung ist dabei auch als Maß für die Güte des Verfahrens heranziehbar. Bei idealer Vektorisierung ist der zeitliche Abstand zwischen den einzelnen Vektoren konstant.

Das darauf folgende Verfahren zur Datenreduktion untergliedert sich in die folgenden grundlegenden Schritte/Methoden, wobei nur die Schritte 1 bis 3 in der beschriebenen oder abgewandelten Form notwendig sind, während die anderen genannten Schritte als vorteilhafte Ausgestaltungen dienen:

1. Gleichrichtung und Umhüllung des Ultraschallsignals

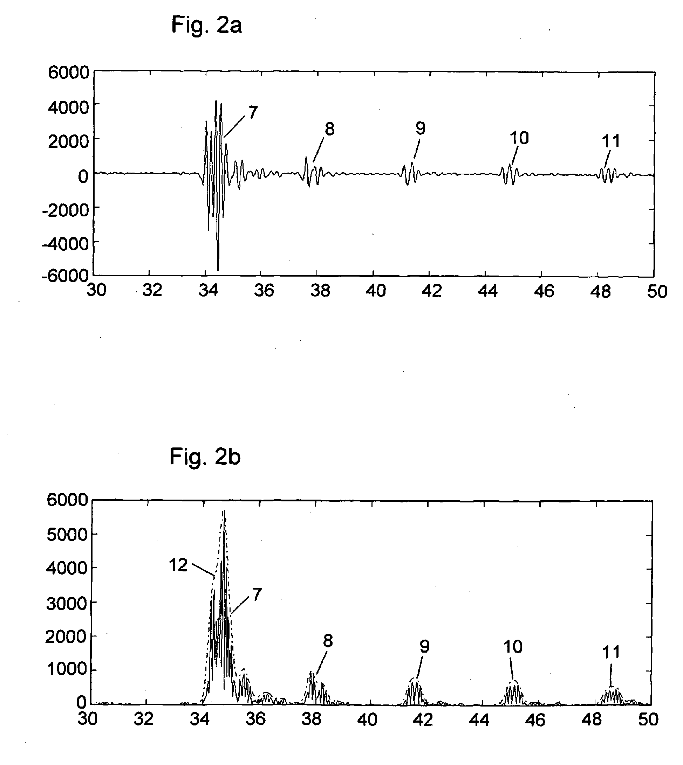

**Fig.2a** gibt den Signalverlauf der durch den Ultraschallprüfkopf **1** empfangenen Echoimpulse über die Zeit wieder. Neben dem ersten Rückwandecho **7** sind das zweite, dritte, vierte und fünfte Rückwandecho **8 bis 11** des Ultraschallimpulses ohne eine weitere Nachbearbeitung dargestellt. Der Bereich vor dem ersten Rückwandecho wird durch die Laufzeit durch die Vorlaufstrecke bestimmt. Die zeitlichen Abstände zwischen den einzelnen Rückwandechos sind jeweils gleich und entsprechen jeweils der doppelten Laufzeit durch die Rohrwandung.

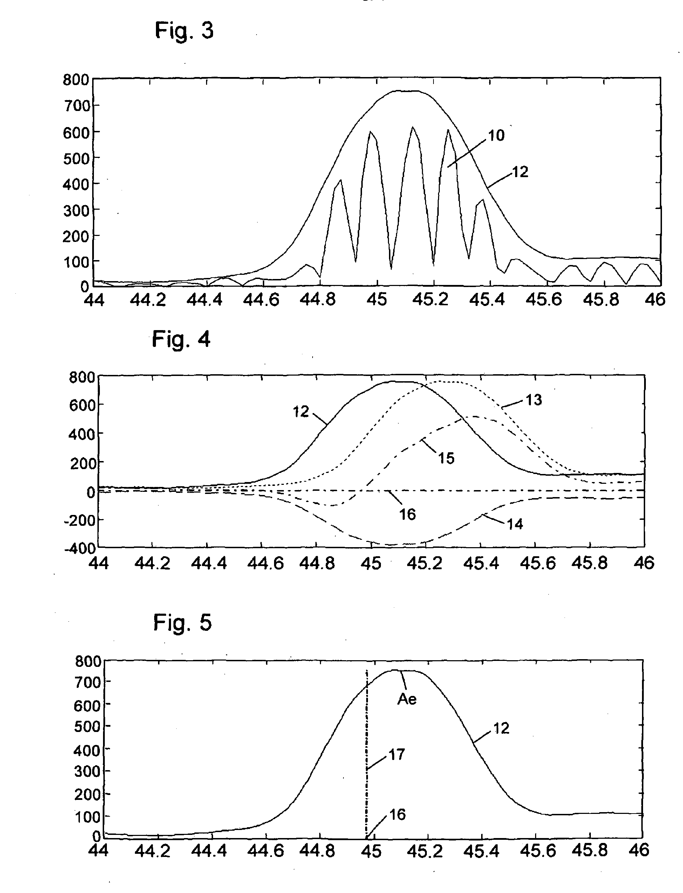

Das empfangene Signal wird in einem ersten Schritt gleichgerichtet und mit einer Umhüllungskurve **12** (Einhüllende, Envelope) versehen (**Fig.2b**), wobei jene sich an den jeweiligen Maxima des gleichgerichteten Signals orientiert. Das gleichgerichtete Echosignal im zeitlichen Abschnitt um das vierte Rückwandecho ist in **Fig.3** wiedergegeben. Wie auch die anderen Rückwandechos umfasst es mehrere oftmals nahezu gleich hohe Schwingungen, typisch für eine impulsförmige Anregung insbesondere von schwach gedämpften Ultraschallprüfköpfen.

Die Einhüllende des Ultraschallechos erfolgt vorzugsweise durch einen digitalen Tiefpass, besonders bevorzugt durch einen sog. CIC-Filter (kaskadiertes Integrator-Differentiator-Filter). Beim CIC-Filter handelt es sich um einen speziellen digitalen FIR-Filter und lassen sich sehr vorteilhaft in digitaler Hardware wie FPGAs (Field Programmable Gate Array) implementieren, da alle Koeffizienten des Filters "1" und damit keine rechenintensive Multiplikationen notwendig sind (siehe **Fig.2b** und **Fig.3**).

2. Amplitudenunabhängige Triggerung zur Bestimmung der Laufzeit

Die Laufzeit wird durch einen Algorithmus zur Triggerung (Diskriminierung) in der Signalflanke der Einhüllenden berechnet, und zwar unabhängig von der Signalhöhe. Dabei erfolgt die Triggerung nicht anhand eines Signalüberschreitung oder Signalübertritts einer vorgegebenen fixen Schwelle sondern bei Erreichen einer bestimmten Signalhöhe in Abhängigkeit von der maximalen Impulshöhe (in der Regel zwischen 0,3 - 0,6 der Impulshöhe eines jeden Rückwandechos bzw. deren Umhüllenden). Um dies zu erreichen wird das gleichgerichtete und umhüllte Signal (Umhüllungskurve **12**) in zwei verschiedene Pfade eingespeist. Auf dem einen Pfad wird es zu einem Verzögerungssignal **13** (verzögertes Umhüllungskurvensignal) verzögert. Auf dem anderen Pfad wird das gleiche gleichgerichtete und umhüllte Signal um einen gewissen Teilungsfaktor f zu einem gedämpften Signal abgeschwächt zu einem invertierten gedämpften Umhüllungskurvensignal **14** umgeklappt (siehe **Fig.4**). Das inverse gedämpfte Signal wird mit dem Verzögerungssignal zu einem Summensignal **15** gemäß

$$A_{res}(t) = A_e(t-t_d) - f \cdot A_e(t) \qquad (1)$$

addiert, wobei $A_{res}$ die Amplitude des resultierenden Signals, $A_e$ die Amplitude des Eingangssignals sowie $t_d$ die Zeit um die das Eingangssignal verzögert wird, ist.

Der positive Nulldurchgang **16** des Signal $A_{res}$ (**Fig.4**) wird nun als Triggerzeitpunkt $t_{trigger}$ definiert. Dieser Zeitpunkt $t_{trigger}$ ist von der Steigung m der Pulse (m = $\Delta A/\Delta t$), dem Bruchteil f und von der Verzögerung $t_d$ abhängig (ttrigger = ttrigger (m, f, $t_d$)), nicht aber von der Amplitudenhöhe.

3. Bestimmung der Amplitude

Die Verzögerungszeit $t_d$ wird so gewählt, dass der Triggerzeitpunkt $t_{trigger}$ im Bereich der Amplitude des Eingangssignals $A_e$ liegt. Um den Zeitwert $t_{trigger}$ wird nun in einem definierten Zeitbereich das Maximum von $A_e$ bestimmt und als Amplitudenwert Am im Speicher abgelegt. Das Amplituden-Laufzeit-Paare Am und $t_{trigger}$ beschreiben nun den Ultraschallvektor **17** (siehe **Fig.5**).

4. Selektion von Vektoren

Vektoren, deren Amplituden unterhalb einer einstellbaren parametrisierten Schwelle liegen, werden optional eliminiert. Damit werden Rauschsignale eliminiert.

5. Optionen

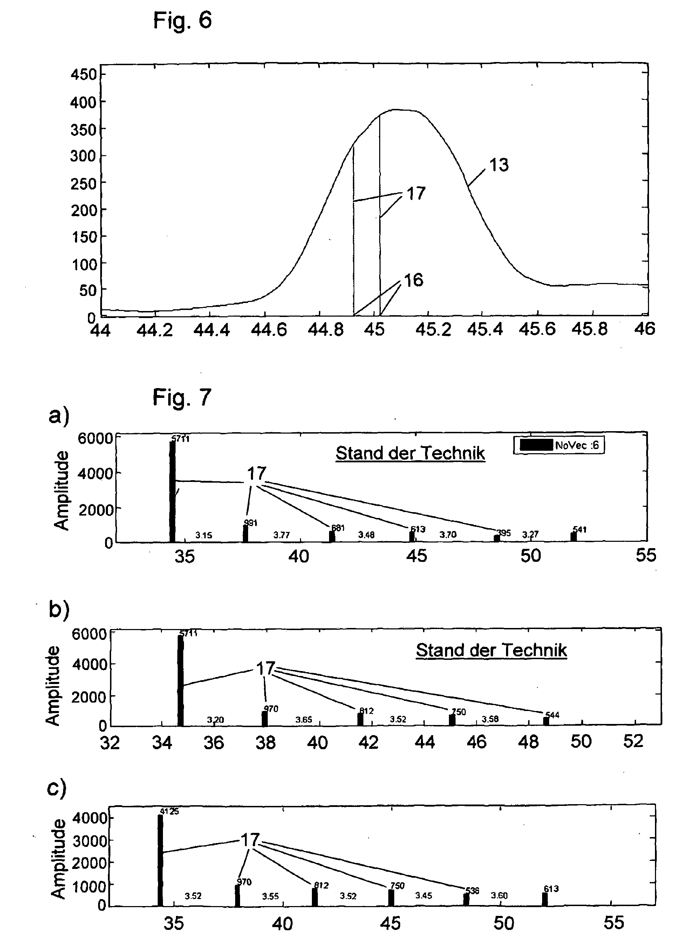

Die Abhängigkeit des Triggerzeitpunktes von der Steigung m des Signals ist zur Bestimmung oder Charakterisierung der Form der Einhüllenden heranziehbar. Die zeitliche Differenz des Triggerzeitpunktes bei verschiedenen Abschwächfaktoren f ist ein Maß für die Steilheit m und damit für die Form des Signals (siehe **Fig.6**). Wird dieser Differenzwert noch zusätzlich zu Amplitude und Laufzeit mit abgespeichert, so kann die offline-Defektbestimmung noch genauer erfolgen.

Das anhand **Fig.6** erläuterte Verfahren umfasst eine Erzeugung eines zweiten negativen und im Beispiel um einen zweiten Faktor f=0,6 ungleich des ersten Faktors f=0,4 reduzierten Umhüllungskurvensignals sowie eines unveränderten, jedoch um eine Zeitspanne $t_d$ verzögerten Umhüllungskurvensignals für jeden Ultraschallimpuls. Es folgt eine Addition des zweiten negativ reduzierten und des verzögerten Umhüllungskurvensignals zu einem zweiten Summensignal mit einem zweiten Nulldurchgang, wobei der zweite Nulldurchgang einen zweiten Zeitwert darstellt sowie eine Zuordnung einer Steigung zum ersten und zweiten Zeitwert wie zuvor beschrieben. Dabei bestimmt sich der Zeitwert aus der Zeitspanne aus ersten und zweiten Zeitwert sowie des Differenzsignals des Umhüllungskurvensignals zwischen den Signalwerten des ersten und zweiten Zeitwerts ermittelt.

**Fig.7a bis c** zeigen vergleichende Vektorisierungen von Ultraschalldaten eines und vom Ultraschallprüfkopf empfangenen Ultraschallausgangssignals mit verschiedenen Verfahren am Beispiel eines Ultraschallsignals von einer Wanddickenmessung (vgl. **Fig.2a**). Die zeitlichen Abstände zwischen den einzelnen Rückwandechos sind jeweils gleich und entsprechen jeweils der doppelten Laufzeit durch die Rohrwandung. Bei idealer Vektorisierung ist der zeitliche Abstand zwischen den einzelnen Vektoren ebenfalls konstant, weshalb die zeitlichen Abstände zum Vergleich verschiedener Verfahren herangezogen wurden.

Als Maß für die Güte der Vektorisierung dient die Bestimmung der Varianz der genannten zeitlichen Abstände zwischen den Vektoren.

**Fig.7a** zeigt eine Vektorisierung basierend auf der Auswahl von Maxima aus einer Folge von Spitzenwerten gemäß des Stands der Technik **[3]**, die Varianz der Zeitdifferenzen beträgt 71,6 ns.

Wird statt der Selektion der Halbwellenmaxima eine CIC Einhüllende gebildet und anschließend eine Spitzenwertdetektion gem. des Stands der Technik **[2]** durchgeführt (siehe **Fig.7b**), so erniedrigt sich die Varianz der Zeitdifferenzen auf 39,4 ns.

**Fig.7c** zeigt dagegen eine Vektorisierung gemäß eines Verfahrens mit vorgenannter Gleichrichtung und Umhüllung des Ultraschallsignals, Amplitudenunabhängige Triggerung zur Bestimmung der Laufzeit und Bestimmung der Amplitude (vgl. **Fig.2b bis 5**). Die Varianz der zeitlichen Abstände reduziert sich auf 2,9ns.

Das beschriebene Verfahren erbringt im Vergleich zum zitierten Stand der Technik eine signifikante Verbesserung bei der Vektorisierung, speziell bei der Zeitbestimmung. Dadurch kann z.B. die Genauigkeit der Wanddickenmessung wesentlich verbessert werden.

Auch in der medizinischen Ultraschalldiagnostik wir z.B. der Ultraschallcomputertomographie (USCT) ermöglicht die exaktere Zeitmessung eine genauere Geschwindigkeitsmessung und damit auch eine präzisere Ortsauflösung in unterschiedlichen Geweben.

**Literatur**

[1] Barbian O. A., Grohs B., Licht R.: Signalanhebung durch Entstörung von Laufzeit-Meßwerten aus Ultraschallprüfungen von ferritischen und austenitischen Werkstoffen - ALOK, Teil 1; Materialprüfung 23 (1981) 379 - 383
[2] DE 40 40 190 A1
[3] DE 10 2005 005 386 B3

**Bezugszeichenliste**

1    Ultraschallprüfkopf

2    Rohrwandung

3    Innenwand

4    Außenwand

5    Vorlaufstrecke

6    Pfeile

7    erstes Rückwandecho

8    zweites Rückwandecho

9    drittes Rückwandecho

10    viertes Rückwandecho

11    fünftes Rückwandecho

12 Umhüllungskurve

13 Verzögerungssignal

14 inverses gedämpftes Signal

15 Summensignal

16 Nulldurchgang

17 Vektor

**Patentansprüche**

1. Verfahren zur Reduktion von Ultraschalldaten aus einem mehrere Ultraschallimpulse umfassenden Ultraschallsignal, umfassend die folgenden Verfahrensschritte:

   a) Gleichrichtung des Ultraschallsignals,
   b) Generierung einer Umhüllungskurve **(12)** um die Maximalwerte des gleichgerichteten Ultraschallsignals, wobei sich die Ultraschallimpulse jeweils als Kurvenabschnitte mit einfachem Maximalwert darstellen,
   c) Erzeugung eines ersten negativen und um einen ersten Faktor f reduzierten Umhüllungskurvensignals **(14)** sowie eines unveränderten, jedoch um eine Zeitspanne $t_d$ verzögerten Umhüllungskurvensignals **(13)** für jeden Ultraschallimpuls,
   d) Addition des ersten negativ reduzierten und des verzögerten Umhüllungskurvensignals zu einem ersten Summensignal **(15)** mit einem ersten Nulldurchgang **(16)**, wobei der erste Nulldurchgang einen ersten Zeitwert darstellt sowie
   e) Zuordnung einer Amplitude zum ersten Zeitwert, wobei die Amplitude einer Signalhöhe entsprechend einer maximalen Peakhöhe aus der Umhüllungskurve (12) innerhalb eines Zeitintervalls um den ersten Zeitwert entspricht.

2. Verfahren nach Anspruch 1, **dadurch gekennzeichnet, dass** das Zeitintervall durch die Halbwertsbreiten der Umhüllungskurve um den ersten Zeitwert begrenzt ist.

3. Verfahren nach Anspruch 1 oder 2, umfassend:

   a) eine Erzeugung eines zweiten negativen und um einen zweiten Faktor ungleich des ersten Faktors reduzierten Umhüllungskurvensignals sowie eines unveränderten, jedoch um eine Zeitspanne $t_d$ verzögerten Umhüllungskurvensignals für jeden Ultraschallimpuls,
   b) Addition des zweiten negativ reduzierten und des verzögerten Umhüllungskurvensignals zu einem zweiten Summensignal mit einem zweiten Nulldurchgang, wobei der zweite Nulldurchgang einen zweiten Zeitwert darstellt sowie
   c) eine Zuordnung einer Steigung zum ersten und zweiten Zeitwert, wobei sich der Zeitwert aus der Zeitspanne aus ersten und zweiten Zeitwert sowie des Differenzsignals des Umhüllungskurvensignals zwischen den Signalwerten des ersten und zweiten Zeitwerts ermittelt.

4. Verfahren nach Anspruch 1 oder 2, umfassend:

   a) eine Erzeugung eines zweiten Zeitwerts zum Zeitpunkt der aufsteigenden Halbwertsbreite der Umhüllungskurve vor dem ersten Zeitwert sowie
   b) eine Zuordnung einer Steigung zum ersten und zweiten Zeitwert, wobei sich der Zeitwert aus der Zeitspanne aus ersten und zweiten Zeitwert sowie des Differenzsignals des Umhüllungskurvensignals zwischen den Signalwerten des ersten und zweiten Zeitwerts ermittelt.

5. Verfahren nach Anspruch 3 oder 4, **dadurch gekennzeichnet, dass** jeder Zeitwert mit der dazugehörigen Amplitude und jedes Zeitwertpaar mit der dazugehörigen Steigung je einen Vektor bilden und die Vektoren, die Amplituden unterhalb eines Schwellwerts aufweisen, aus den Ultraschalldaten ausgeschieden werden.

6. Verfahren nach einem der vorgenannten Ansprüche, **dadurch gekennzeichnet, dass** der Faktor konstant ist und zwischen 0,3 bis 0,6 liegt.

**Claims**

1. Method for reducing ultrasound data from one ultrasound signal comprising multiple ultrasound pulses, comprising the following steps in the method:

   a) rectification of the ultrasound signal,
   b) generation of an envelope curve (12) around the maximum values of the rectified ultrasound signal, wherein the ultrasound pulses are represented in each case as curve sections with a single maximum value,
   c) generation of a first negative envelope curve signal (14) reduced by a first factor f, and of an envelope curve signal for each ultrasound pulse, said signal not being modified but being delayed by a time period $t_d$,
   d) addition of the first negatively reduced envelope curve signal and of the delayed envelope curve signal to form a first sum signal (15) with a first zero crossing (16), wherein the first zero crossing represents a first time value, and
   e) allocation of an amplitude to the first time value, wherein the amplitude corresponds to a signal height consistent with a maximum peak height from the envelope curve within a time interval about the first time value.

2. Method according to claim 1, **characterised in that** the time interval is limited by the half-value widths of the envelope curve about the first time value.

3. Method according to claim 1 or 2, comprising:

   a) the generation of a second negative envelope curve signal reduced by a second factor not the same as the first factor, and of an envelope curve signal for each ultrasound pulse, said signal not being modified but being delayed by a time period $t_d$,
   b) Addition of the second negatively reduced envelope curve signal and the delayed envelope curve signal to form a second sum signal with a second zero crossing, wherein the second zero crossing represents a second time value, and
   c) an allocation of a slope to the first and second time value, wherein the time value is determined from gap between the first and second time value and the difference signal of the envelope curve signal between the signal values of the first and second time value.

4. Method according to claim 1 or 2, comprising:

   a) a generation of a second time value at the time of the rising half-value width of the envelope curve before the first time value and
   b) an allocation of a slope to the first and second time value, wherein the time value is determined from gap between the first and second time value and the difference signal of the envelope curve signal between the signal values of the first and second time value.

5. Method according to claim 3 or 4, **characterised in that** each time value with the associated amplitude and each time value pair with the associated slope each form a vector and the vectors which have amplitudes below a threshold value are eliminated from the ultrasound data.

6. Method according to any one of the preceding claims, **characterised in that** the factor is constant and lies between 0.3 and 0.6.

**Revendications**

1. Procédé permettant de réduire des données ultrasoniques d'un signal ultrasonique renfermant plusieurs impulsions ultrasoniques, comprenant les étapes consistant à :

   a) redresser le signal ultrasonique,
   b) générer une courbe enveloppe (12) autour des valeurs maximum du signal ultrasonique redressé, les impulsions ultrasoniques se représentant respectivement sous la forme de segments de courbe ayant une valeur maximum simple,

c) produire un premier signal de courbe enveloppe négatif (14) et réduit d'un premier facteur f, ainsi qu'un signal de courbe enveloppe (13) non modifié, mais toutefois retardé d'un temps $t_d$ pour chaque impulsion de signal ultrasonique,

d) ajouter le premier signal de courbe enveloppe réduit négatif et le signal de courbe enveloppe retardé pour obtenir un premier signal de somme (15) avec un premier passage par zéro (16), le premier passage par zéro représentant une première valeur de temps, et

e) associer une amplitude à la première valeur de temps, cette amplitude correspondant à une hauteur de signal correspondant à une hauteur de pic maximum dans la courbe enveloppe (12) au cours d'un intervalle de temps autour de la première valeur de temps.

2. Procédé conforme à la revendication 1,
**caractérisé en ce que**
l'intervalle de temps est limité par les largeurs de bande à mi-hauteur de pic de la courbe enveloppe autour de la première valeur de temps.

3. Procédé conforme à la revendication 1 ou 2, comprenant :

a) l'obtention d'un second signal de courbe enveloppe négatif et réduit d'un second facteur différent du premier facteur ainsi qu'un signal de courbe enveloppe non modifié mais toutefois retardé d'un temps $t_d$ pour chaque impulsion ultrasonique,

b) l'addition du second signal de courbe enveloppe réduit et du signal de courbe retardé pour obtenir un second signal de somme avec une second passage par zéro, le second passage par zéro représentant une seconde valeur de temps, et

c) l'association d'une pente à la première et à la seconde valeur de temps, la valeur de temps étant déterminée à partir de l'intervalle de temps entre la première et la seconde valeur de temps ainsi que du signal différentiel du signal de courbe enveloppe entre les valeurs de signal de la première ou de la seconde valeur de temps.

4. Procédé conforme à la revendication 1 ou 2, comprenant :

a) l'obtention d'une seconde valeur de temps à l'instant de la montée de la largeur de bande à mi-hauteur de pic de la courbe enveloppe avant la première valeur de temps, et

b) l'association d'une pente à la première et à la seconde valeur de temps, la valeur de temps étant déterminée à partir du temps, entre la première et la seconde valeur de temps ainsi que du signal différentiel du signal de courbe enveloppe entre les valeurs de signal de la première et de la seconde valeur de temps.

5. Procédé conforme à la revendication 3 ou 4,
**caractérisé en ce que**
chaque valeur de temps avec l'amplitude associée et chaque paire de valeurs de temps avec la pente associée forment respectivement un vecteur, et les vecteurs qui présentent des amplitudes situées en-dessous d'une valeur de seuil sont éliminées des données ultrasoniques.

6. Procédé conforme à l'une des revendications précédentes, **caractérisé en ce que**
le facteur est constant et est compris entre 0.3 et 0.6.

Fig. 1

## Fig. 2a

## Fig. 2b

## Fig. 3

## Fig. 4

## Fig. 5

Fig. 6

Fig. 7

a)

b)

c)

**IN DER BESCHREIBUNG AUFGEFÜHRTE DOKUMENTE**

**In der Beschreibung aufgeführte Patentdokumente**

- DE 4040190 A1
- DE 102005005386 B3

**In der Beschreibung aufgeführte Nicht-Patentliteratur**

- **BARBIAN O. A. ; GROHS B. ; LICHT R.** Signalanhebung durch Entstörung von Laufzeit-Meßwerten aus Ultraschallprüfungen von ferritischen und austenitischen Werkstoffen - ALOK. *Materialprüfung,* 1981, vol. 23, 379-383